Europäisches Patentamt

European Patent Office

Office européen des brevets

(11) Veröffentlichungsnummer: **0 517 037 A2**

# EUROPÄISCHE PATENTANMELDUNG

(21) Anmeldenummer: **92108543.7**

(51) Int. Cl.5: **H03K 17/78**

(22) Anmeldetag: **20.05.92**

(30) Priorität: **05.06.91 DE 4118442**

(43) Veröffentlichungstag der Anmeldung:
**09.12.92 Patentblatt 92/50**

(84) Benannte Vertragsstaaten:
**DE FR GB IT NL**

(71) Anmelder: **SIEMENS AKTIENGESELLSCHAFT**
**Wittelsbacherplatz 2**
**W-8000 München 2(DE)**

(72) Erfinder: **Albrecht, Helmut, Dr.-Ing**
**Wessobrunner Platz 9a**
**W-8000 München 70(DE)**
Erfinder: **Emeis, Norbert, Dr.-Ing**
**Balanstrasse 63**
**W-8000 München 90(DE)**

(54) **Kaskadierbarer Netzwerkkonfigurationsmodul.**

(57) Kaskadierbarer Netzwerkkonfigurationsmodul für die Vernetzung optischer Signalwege, bei dem die Betätigung eines optischen Schalters (1) in einem Signalweg mittels einer elektronischen Schaltung, speziell mittels eines R-S-Flip-Flops (3), dadurch gesteuert wird, daß durch Photodioden (2), die in dem optischen Signalweg integriert sind, mit dem Nutzsignal zusammen übermittelte Steuersignale detektiert werden.

FIG 1

Die vorliegende Anmeldung betrifft einen kaskadierbaren, monolithisch integrierten Netzwerkkonfigurationsmodul

Das Konfigurieren von optischen Netzwerken gewinnt in der optischen Informationstechnik, Verbindungstechnik und Signalverarbeitung sowie im optischen Computer immer mehr an Bedeutung. Entscheidend dabei ist die technische Realisierung der optischen Knotenpunkte solcher Systeme. Aufgabe eines solchen Knotens ist das Verteilen eines am Eingang anliegenden optischen Informations-(Nutz-)signales Ps mit der Wellenlänge Ls auf verschiedene Ausgänge. Optische Schalter mit einem Eingang und zwei Ausgängen können Basiszellen solcher Netze sein: Je nach Anforderung kann die Information durch eine Verbindung vom Eingang zum Ausgang I bzw. zum Ausgang II übertragen werden. Die Steuerung des optischen Schalters selbst erfolgt entweder im Zeitbereich mittels eines sogenannten Headers oder mit Hilfe eines optischen Steuersignals Pc mit der Wellenlänge Lc. Die Aufgabe dieses komplexen Bausteines bzw. Moduls umfaßt somit Steuerung, Verteilung und Informationsübertragung. Um Netzwerke zu konfigurieren, müssen diese Module kaskadierfähig sein (Netzwerkkonfigurationsmodul (NCM)).

Aufgabe der vorliegenden Erfindung ist es, einen monolithisch integrierten Netzwerkkonfigurationsmodul anzugeben, bei dem die Steuerung des Schalters in möglichst einfacher Weise erfolgen kann.

Diese Aufgabe wird mit dem NCM mit den Merkmalen des Anspruches 1 bzw. mit den Merkmalen des Anspruches 9 gelöst. Weitere Ausgestaltungen ergeben sich aus den abhängigen Ansprüchen.

Bei dem erfindungsgemäßen NCM ist eine elektronische Steuerschaltung für die Betätigung des Schalters monolithisch integriert. Der optische Schalter kann bei diesem NCM durch ein Steuersignal betätigt werden, das durch in die Signalwege integrierte Photodioden detektiert wird.

Es folgt eine Beschreibung des erfindungsgemäßen NCM anhand der Figuren 1 bis 11.

Fig. 1 zeigt ein Blockschaltbild des erfindungsgemäßen NCM.

Fig. 2 zeigt das elektrische Ersatzschaltbild des optisch getriggerten Flip-Flops.

Fig. 3 und 4 zeigen Diagramme für die Signale am Eingang und an den Ausgängen des Schalters.

Fig. 5 und 6 zeigen Blockschaltbilder für das Zusammenschalten mehrerer NCMs.

Fig. 7 zeigt einen erfindungsgemäßen NCM in Aufsicht im Schema.

Fig. 8 bis 11 zeigen den Schichtaufbau für monolithische Integration der Komponenten des NCMs im Querschnitt.

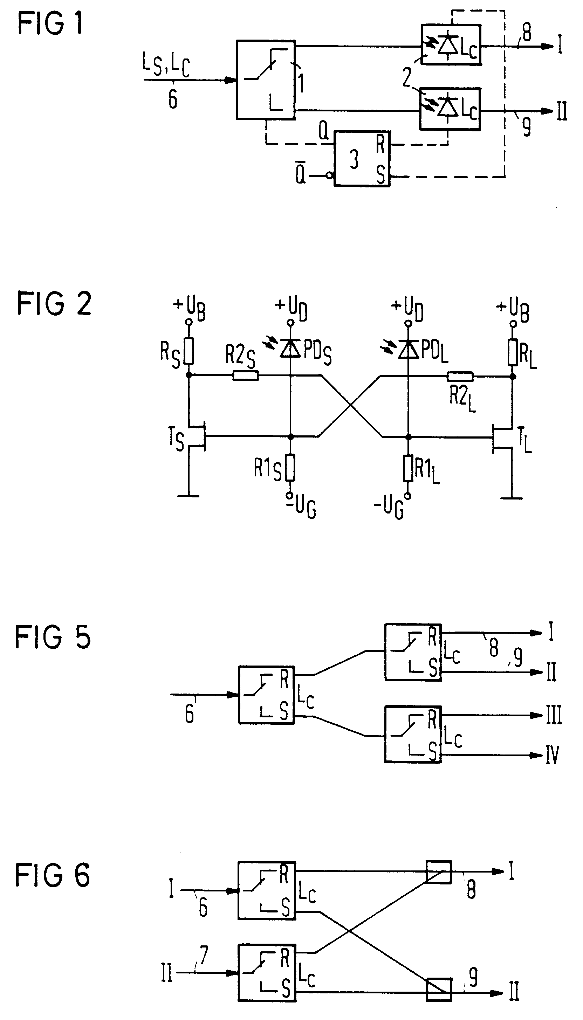

Fig. 1 zeigt das Blockschaltbild des erfindungsgemäßen NCM-Bausteins, der aus einem optischen Schalter 1 und aus zwei optisch schwach angekoppelten Photodioden 2 sowie einem optisch getriggerten R-S-Flip-Flop 3 als Treiber für diesen Schalter 1 besteht. Die optischen Wellenlängen für das Nutzsignal und das Steuersignal müssen sich entsprechend der Wellenlängenselektivität der Photodiodenanordnung unterscheiden, damit das Nutzsignal keine Steuerimpulse in den Photodioden erzeugt und ungedämpft weitergeleitet werden kann. Die Wellenlänge Ls für das Nutzsignal und die Wellenlänge Lc für das Steuersignal erreichen gemeinsam den Eingang 6 des Schalters 1 und erreichen von da aus einen der Ausgänge 8, 9, die mit I bzw. II bezeichnet sind. In den Ausgängen befinden sich jeweils die Photodioden 2, die das Steuersignal Lc detektieren. Mit den durchgehenden Linien sind in Fig. 1 die optischen Wellenleiter bezeichnet; mit den gestrichelten Linien sind die elektrischen Steuerströme zwischen den Photodioden und dem RS-Flip-Flop 3 bzw. zwischen dem Flip-Flop und dem Schalter 1 bezeichnet.

In Fig. 2 ist das elektrische Ersatzschaltbild des optisch getriggerten Flip-Flops dargestellt. Die Wirkungsweise der elektronischen Schaltung wird anhand von Feldeffekttransistoren des Normally-off-Typs beschrieben. Der "Aus"-Zustand ist so eingestellt, daß am optischen Schalter ($R_S$) nur eine sehr kleine Spannungsdifferenz anliegt, d. h. der Transistor $T_S$ ist im Sperrbetrieb und der Transistor $T_L$ im Durchlaßbetrieb. Der Spannungsteiler $R_S$, $R2_S$ und $R1_L$ hält den Betriebszustand von $T_1$ aufrecht. Damit liegt am Gate von $T_S$ die für den Sperrbetrieb notwendige negative Vorspannung $U_G$. Bei Anliegen eines kurzen optischen Steuerimpulses Pc wird in der Photodiode $PD_S$ (Wellenleiter-Photodiode-Kopplung am Ausgang I des Schalters) ein elektrischer "Set"-Photostromimpuls und als dessen Folge im Widerstand $R1_S$ ein Spannungsimpuls erzeugt, der den Transistor $T_S$ vom Sperrbetrieb in den Durchlaßbetrieb schaltet. Durch die geänderten Potentialverhältnisse liegt nun die erforderliche Spannungsdifferenz zum Betätigen des optischen Schalters an und stellt somit den "Ein"-Zustand her. Dadurch wird der Transistor $T_L$ in den Sperrbetrieb geschaltet. Die zur Aufrechterhaltung des Durchlaßbetriebes von $T_S$ erforderliche Spannung wird jetzt durch den Spannungsteiler $R_L$, $R2_L$ und $Rl_S$ geliefert. Das Zurückschalten des Flip-Flops erfolgt in analoger Reihenfolge. Durch einen kurzen optischen Steuerimpuls Pc, detektiert mit der Photodiode $PD_L$ - (Wellenleiter-Photodiode-Kopplung am Ausgang II des Schalters) wird ein elektrischer "Reset"-Impuls generiert, der den Transistor $T_L$ vom Sperrbetrieb in den Durchlaßbetrieb schaltet. Die Spannung für den Durchlaßbetrieb am Gate des $T_S$ bricht zusammen und der Transistor $T_S$ wird in den Sperrbetrieb geschaltet. Da am optischen Schalter wieder nur eine sehr kleine Spannungsdifferenz auftritt, kehrt dieser in den "Aus"-Zustand zurück. Der optische Schalter selbst wird direkt vom Transistor $T_S$ gesteuert. Möglich ist aber auch eine Steuerung des Schalters ($R_S$) durch den Spannungsabfall am parallel zum Schalter liegenden Arbeitswiderstand im Drain-Kreis von $T_S$.

Durch geeignete Dimensionierung der Widerstände in Verbindung mit der Eingangskapazität der Transistoren ist gewährleistet, daß die Umschaltung der Transistoren auf der abfallenden Flanke des optischen Steuersignales erfolgt und damit ein sicherer und definierter Betrieb des R-S-Flip-Flops sowie des Moduls gegeben ist.

Als Transistoren, die hier als elektronische Schalter wirken, können neben den beschriebenen Normally-off-FETs bei Änderung der Vorspannung auch Normally-on-FETs oder Bipolartransistoren eingesetzt werden. Auch können anstelle von Photodioden und Transistoren Phototransistoren oder Photofeldeffekttransistoren Verwendung finden, ohne daß die Eigenschaft und die Wirkungsweise der Schaltung sich ändert.

Aus der Eigenschaft dieser Schaltung resultiert die Funktionsweise des Moduls. Im "Aus"-Zustand wird das optische Informationssignal Ps mit der Wellenlänge Ls vom Eingang des Schalters 1 auf den Ausgang I 8 übertragen. Durch Senden eines zeitlich kurzen optischen Steuersignales Pc mit Wellenlänge Lc wird in der am Ausgang I 8 liegenden Photodiode 2 ein Steuer(Set-)Impuls erzeugt, der das R-S-Flip-Flop umschaltet und den Schalter 1 betätigt. Damit ist der Eingang 6 mit dem Ausgang II 9 verbunden ("Ein"-Zustand), und das Nutzsignal Ps wird auf den Ausgang II 9 übertragen.

Das Senden eines weiteren zeitlich kurzen optischen Steuersignales Pc mit gleicher Wellenlänge Lc löst jetzt einen Steuer-(Reset-)Impuls in der am Ausgang II 9 liegenden Photodiode 2 aus, der das R-S-Flip-Flop zurückschaltet und den Schalter 1 in den "Aus"-Zustand bringt. Damit wird das Nutzsignal Ps wieder vom Eingang 6 auf den Ausgang I 8 übertragen. Da hier zwei elektrisch stabile Zustände vorliegen (Flip-Flop), hat dieser erfindungsgemäße NCM den Charakter einer Speicherzelle, die die Steuersignale erkennt und verarbeitet (intelligenter optischer Schalter).

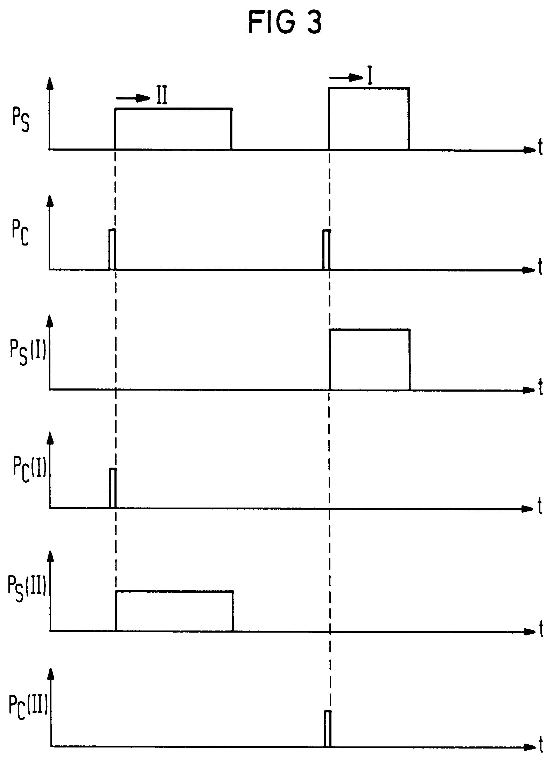

In Fig. 3 sind Diagramme dargestellt, die die Funktionsweise des NCM demonstrieren (Vermitteln von Informationspaketen). Das erste Diagramm zeigt das Nutzsignal Ps am Eingang des Schalters in Abhängigkeit von der Zeit. Das zweite Diagramm zeigt das Steuersignal Pc am Eingang des Schalters. Die nachfolgenden vier Diagramme zeigen jeweils das Nutz- und das Steuersignal am Ausgang I bzw. Ausgang II des Schalters. Durch ein erstes Steuersignal Pc, das vom Eingang des Schalters zum Ausgang I geführt wird (s. zweites und viertes Diagramm) wird der Schalter auf den Ausgang II umgeschaltet. Das nachfolgende Nutzsignal Ps gelangt vom Eingang des Schalters zum Ausgang II (s. erstes und fünftes Diagramm). Ein zweiter Steuerimpuls Pc, der vom Eingang des Schalters zum Ausgang II gelangt (s. zweites und sechstes Diagramm) wird von der Photodiode in Ausgang II detektiert und bewirkt ein Umschalten des Schalters zurück auf Ausgang I. Das Nutzsignal Ps gelangt nun vom Eingang des Schalters wieder zu Ausgang I des Schalters (s. erstes und drittes Diagramm).

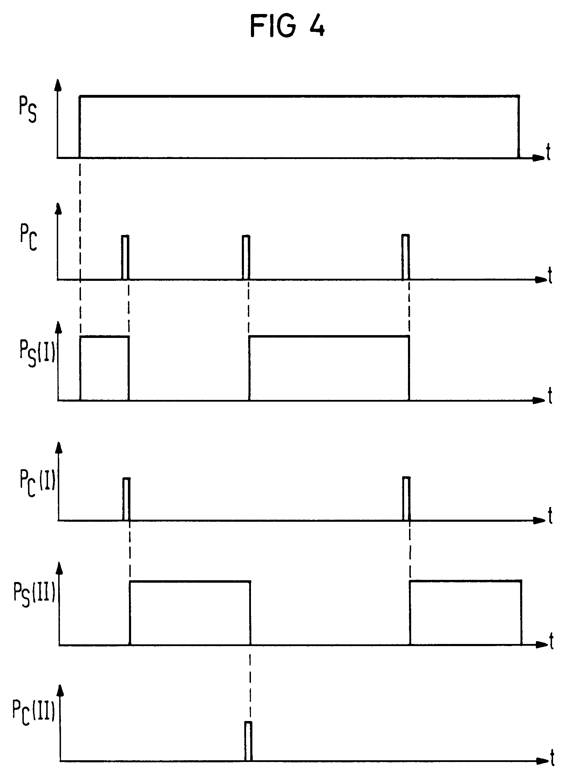

Fig. 4 zeigt eine alternative Funktionsweise anhand von Diagrammen, die denen aus Fig. 3 entsprechen. Es soll bei dieser Funktionsweise ein permanent am Eingang des Schalters anliegendes Nutzsignal Ps alternierend an den Ausgang I bzw. den Ausgang II des Schalters weitergeleitet werden. Das Umschalten des Schalters erfolgt wieder durch das Steuersignal Pc, in dem im zweiten Diagramm gezeigten Beispiel eine Aufeinanderfolge eines Set-Pulses, eines Reset-Pulses und erneut eines Set-Pulses. Die Set-Pulse des Steuersignales gelangen jeweils an den Ausgang I (s. viertes Diagramm); der Reset-Puls gelangt an Ausgang II des Schalters (s. sechstes Diagramm). Aus dem dritten und fünften Diagramm läßt sich die zeitliche Verteilung des Nutzsignales Ps auf die Ausgänge I bzw. II ablesen. Durch jeden gesendeten Steuerpuls Pc wird der Schalter betätigt und das Nutzsignal Ps auf den jeweils anderen Ausgang gelenkt. Eine mögliche Anwendung dieser Funktion ist die Bereitstellung eines optischen Bypasses. Dabei tritt während der Umschaltphase ein geringer Datenverlust auf.

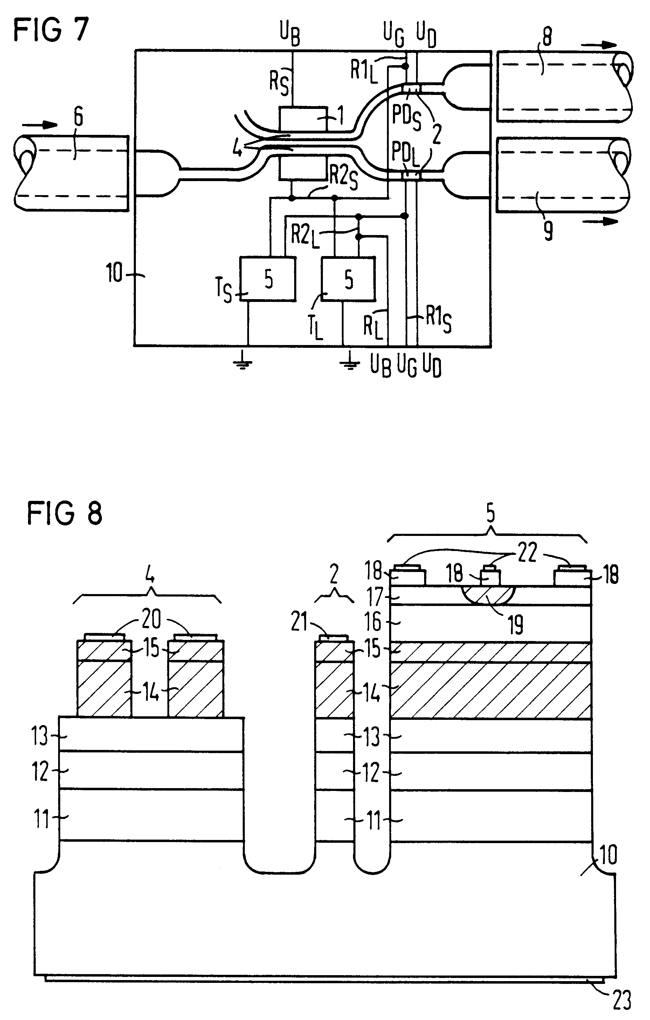

In Fig. 5 ist ein Blockschaltbild für eine Kaskadierung des erfindungsgemäßen NCM dargestellt. Dabei wird das Signal von einem Eingang 6 auf einen von vier verschiedenen Ausgängen (I, II, III und IV) geleitet. Damit ist der Aufbau von Netzwerken mit Baumstruktur möglich, weil durch eine bestimmte Steuerimpulsfolge jeder beliebige Ausgang des Netzwerkes definitiv mit dem Eingang verbunden werden kann, wie man nachstehender Tabelle entnehmen kann.

| Impulsfolge am Eingang | | | Signalübertragung nach Ausgang |
|---|---|---|---|
| 3. Impuls | 2. Impuls | 1. Impuls | |
| 0 | 0 | 0 | I |
| 0 | 0 | I | III |
| 0 | I | I | II |
| I | I | I | IV |

Der Einsatz des erfindungsgemäßen NCMs ist neben der optischen Informations- und Verteiltechnik auch in der optischen Signalverarbeitung sowie im optischen Computer ohne weiters möglich. Als Beispiel soll eine 2 x 2-Schaltmatrix dienen. In Fig. 6 ist der prinzipielle Aufbau einer solchen Matrix dargestellt. Jeder Eingang 6, 7 ist über einen Schalter und einen Koppler mit jedem Ausgang 8, 9 verbunden. Die Schalter sind untereinander durch eine elektrische oder optische Kopplung verbunden. Statt einer solchen Kopplung in Form von Hardware ist es auch möglich, daß die Schalter durch Software starr gekoppelt sind, d. h. an beiden Eingängen 6, 7 werden simultan die gleichen Steuerimpulse gesendet, um einen echten Parallelbetrieb zu gewährleisten und um ein Übersprechen zu verhindern. Damit wird sichergestellt, daß jeder Eingang 6, 7 mit genau einem Ausgang 8, 9 jeweils verbunden ist.

Fig. 7 zeigt den prinzipiellen Aufbau eines NCMs, wie er in Fig. 1 als Blockschaltbild dargestellt ist. Der Eingang 6 und die Ausgänge 8, 9 sind an Glasfasern angeschlossen. Zur Verbesserung der Chip-Faser-Kopplung kann, wie in Fig. 7 dargestellt, ein "getapeter" Wellenleiter, integriert auf dem Chip, eingesetzt werden. Der Schalter 1 ist durch den Richtkoppler 4 realisiert. In die Wellenleiter sind Photodioden 2 integriert. Es sind schematisch zwei FETs 5 und elektrische Verbindungen mit den erforderlichen Widerständen eingezeichnet. Ebenso sind die von außen anzulegenden Potentiale am Rand des Substrates 10 angegeben.

Die Halbleiterschichtstruktur für den erfindungsgemäßen NCM wird im folgenden anhand der Figuren 8 bis 11 beschrieben. Ein vorgeschlagenes Strukturkonzept zur monolithischen Integration der Komponenten, d. h. eines optischen Schalters mit Photodioden und FETs sowie Widerständen, basiert auf bereits bekannten Strukturen für Bauelemente und Prozeßtechnologien, insbesondere im Halbleitermaterialsystem InGaAs/InP und InGaAlAs/InP. Dieses Strukturkonzept ist aber prinzipiell auch auf andere Materialsysteme übertragbar. Als verlustarmer optischer Schalter kommt ein Richtkoppler mit Strominjektion zum Einsatz, wie er z. B. in G. Müller, L. Stoll, G. Schulte-Roth, U. Wolff: "Low current plasma effect optical switch in InP", Electr. Letters 26 (1990), 115 - 116 angegeben ist. Die Dimensionierung des Schalters erfolgt dabei so, daß das Nutzsignal mit Wellenlänge $L_S$ und das Steuersignal mit Wellenlänge $L_C$ jeweils gleichzeitig auf denselben Ausgang geschaltet werden können. Die an den Ausgängen des Moduls auf den Wellenleiter integrierten Photodioden werden so ausgebildet, daß nur ein Teil des Steuersignals Pc zur Erzeugung des elektrischen Steuerimpulses verwendet wird (Ph. Riglet, M. Erman, G. G. Martin, Ph. Jarry, M. Renaud: "High performance pin photodiodes on waveguide for coherent communimations", Proc. ECOC (1990), 301 - 304). Die weiteren Komponenten zur elektrischen Signalverarbeitung wie Widerstände und FETs und deren Technologien zur monolithischen Integration (europäische Patentanmeldung Nr. 0 405 214) stehen bereits zur Verfügung. Gezeigt wurde auch der Einsatz monolithisch integrierter FETs als Treiber für optische Modulatoren (J. H. Abeles, W. K. Chan, F. K. Shokoohi, R. Bhat, M. A. Koza: "Integration of GaAs MESFET drivers with GaAs directional-coupler electro-optic modulators", Electr. Letters. 23 (1990), 1037 - 1038).

Fig. 8 zeigt die Schichtstruktur für ein erstes Ausführungsbeispiel eines monolithisch integrierten NCMs. Die Struktur umfaßt einen Richtkoppler 4 mit elektrisch steuerbaren Rippenwellenleitern und eine monolithisch integrierte Photodiode-FET-Kombination. Die Halbleiterschichten werden epitaxial (z. B. mit Flüssigphasen-, Gasphasen- oder Molekularstrahlepitaxie) auf einem semiisolierenden oder z. B. n-leitenden Substrat 10 aufgewachsen. In Fig. 8 sind auf dem Substrat 10 übereinander eine Pufferschicht 11, eine 1,3 $\mu$m-Wellenleiterschicht 12, eine 1,05 $\mu$m-Wellenleiterschicht 13, eine Führungsschicht 14, eine Zwischenschicht 15, eine Kanalschicht 16, eine Deckschicht 17 und eine Kontaktschicht 18 dargestellt. In dem vorliegenden Ausführungsbeispiel sind das Substrat 10, die Pufferschicht 11, die Kanalschicht 10, die Deckschicht 17 und die Kontaktschicht 18 n-leitend dotiert und die Führungsschicht 14 und die Zwischenschicht 15 p-leitend dotiert. Prinzipiell können die Vorzeichen der Dotierung aber auch vertauscht sein. In den Figuren 8 bis 11 ist die p-Dotierung durch Schraffur dargestellt. Im InP-Materialsystem ist das Substrat 10 z. B. InP:S, die Pufferschicht 11, die auch entfallen kann, InP, die Wellenleiterschichten 12, 13

4

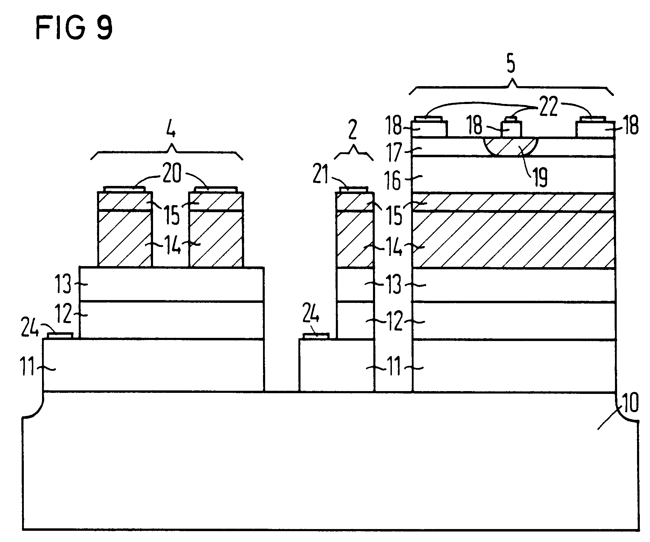

verschiedene quaternäre Zusammensetzungen (InGaAsP), die Führungsschicht 14 und die Deckschicht 17 jeweils InP, die Zwischenschicht 15 InGaAsP (1,3 $\mu$m) und die Kanalschicht 16 sowie die Kontaktschicht 18 jeweils InGaAs. Die Kanalschicht 16 kann in diesen wie auch den übrigen Ausführungsbeispielen weggelassen sein, wenn die Deckschicht 17 im Bereich des FETs 5 als Kanalschicht ausgebildet ist. Der Richtkoppler, die Photodiode 2 und der dargestellte FET 5 sind untereinander jeweils durch Trenngräben, die bis ins Substrat 10 hineinreichen, getrennt. Es sind auf dem Richtkoppler 4, der Photodiode 2 und dem FET 5 sowie auf der der überwachsenen Oberseite gegenüberliegenden Seite des Substrates 10 Kontakte 20, 21, 22, 23 aus Metall für die elektrischen Anschlüsse aufgebracht. Die Deckschicht 17 dient zur Passivierung der obenliegenden pn-Übergänge und die Kontaktschicht 18 dient zur Reduzierung der Kontaktwiderstände. Die Erzeugung des pn-Überganges für den Gatebereich des FETs 5 erfolgt entweder durch Diffusion oder Implanation von Dotierstoff, wodurch das Vorzeichen der Dotierung umgekehrt wird. In dem beschriebenen Ausführungsbeispiel ist der Gatebereich 19 daher p-leitend dotiert. Je nachdem ob ein semiisolierendes oder ein n-leitendes InP-Substrat verwendet wird, ist der allen Funktionselementen gemeinsame n-Kontakt entweder auf einer n-leitend dotierten Pufferschicht 11 wie in Fig. 9 als Kontakt 24 oder als Kontakt 23 wie in Fig. 8 auf der der überwachsenen Oberfläche gegenüberliegenden Seite des Substrates aufgebracht. Im Fall der Ausführungsform mit einem semiisolierenden Substrat entsprechend Fig. 9 ist die Schichtfolge in der Weise abgeätzt, daß auf der Pufferschicht 11 Bereiche für das Aufbringen des Kontaktes 24 freigelassen sind. Bei den verschiedenen Funktionselementen sind die nicht benötigten Schichten durch selektives Ätzen entfernt. Anschließend sind die Gräben für die Trennung der Funktionselemente geätzt. Ein semiisolierendes Substrat ist z. B. aus InP:Fe. Zur Erzielung einer planaren Oberfläche des NCMs kann eine Planarisierung mittels eines Materials geringen Brechungsindexes vorgenommen sein. Die auf den Funktionselementen aufgebrachten p-Kontakte für die Photodiode 2 und den Richtkoppler 4 werden in diesem Falle durch tiefe Kontaktlöcher in dem Material der Planarisierung realisiert.

Bei den Ausführungsbeispielen der Figuren 8 und 9 ist im Bereich der Photodiode 2 die Zwischenschicht 15 die oberste Schicht, auf der sich unmittelbar der entsprechende Kontakt 21 befindet. Bei diesem Ausführungsbeispiel erfolgt die Wandlung des optischen Signales, das der Photodiode über den Wellenleiter zugeführt wird, in elektrischen Strom in der Photodiode mittels des Franz-Keldysh-Effektes. Zu diesem Zweck sind die Führungsschicht 14 und die Zwischenschicht 15 p-leitend dotiert. Durch Anlegen einer entsprechenden Spannung zwischen den Kontakten 21 und 23 wird ein elektrisches Feld in der Photodiode aufgebaut, so daß der Absorptionskoeffizient in der darunter befindlichen Wellenleiterschicht 13 im Bereich der Photodiode 2 so geändert wird, daß ein Steuersignal Pc mit der Wellenlänge Lc zumindest teilweise absorbiert wird, während das ebenfalls diesen Bereich passierende Nutzsignal Ps mit der Wellenlänge Ls keine Absorption erfährt und ungehindert (verlustfrei) durchgelassen wird.

Eine derartige Schichtfolge läßt sich in einem einzigen Epitaxieprozeß herstellen. Dabei wird eine p-leitende Führungsschicht 14 und eine ebenfalls p-leitende Zwischenschicht 15 abgeschieden. Damit ergeben sich epitaktisch gewachsene pn-Übergänge für die Photodiode 2 und für die Steuerelektroden (Kontakte 20) des Richtkopplers.

Im Bereich des FETs 5 bilden diese p-leitenden Schichten eine vergrabene p-Schicht zur elektrischen Abkopplung der Kanalschicht 16 bzw. der Deckschicht 17 von den unterhalb der Führungsschicht 14 angeordneten Schichten.

Alternativ kann beim Herstellen dieser Schichtfolge die Epitaxie nach dem Aufwachsen der Zwischenschicht 15 unterbrochen werden. Die Führungsschicht 14 und die Zwischenschicht 15 werden dann n-leitend abgeschieden. Die pn-Übergänge für den Richtkoppler 4, die Photodiode 2 und für die vergrabene p-Schicht des FETs 5 werden dann durch Diffusion oder Implantation von Dotierstoff erzeugt. In einem zweiten Epitaxieschritt wird dann die restliche Schichtfolge für den FET 5 abgeschieden.

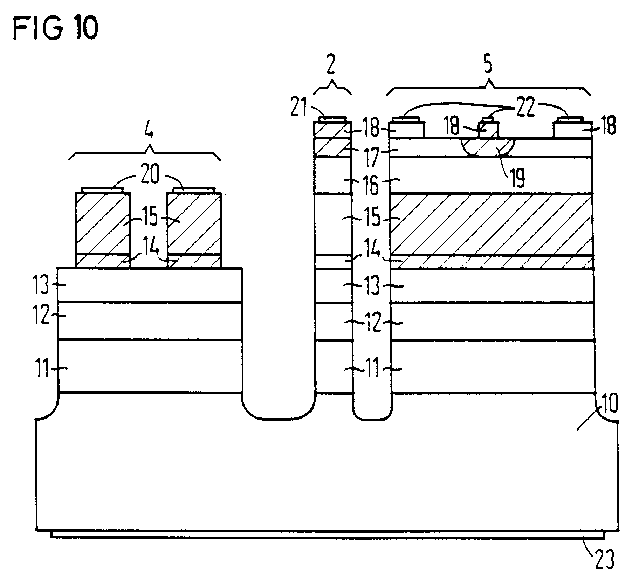

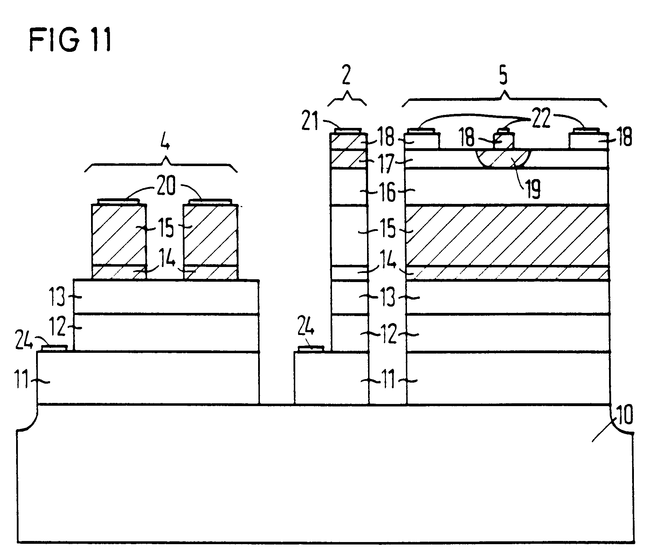

Bei den Ausführungsbeispielen der Figuren 10 und 11 sind die Führungsschicht 14 und die Zwischenschicht 15 nur im Bereich des Richtkopplers 4 und des FETs 5 p-leitend dotiert. Im Bereich der Photodiode 2 ist die gesamte Schichtfolge bis einschließlich der Kontaktschicht 18 vorhanden. Die Führungsschicht 14 und die Zwischenschicht 15 sind hier n-leitend dotiert. Die Deckschicht 17 und die Kontaktschicht 18 sind im Bereich der Photodiode p-leitend dotiert, um den pn-Übergang zu erzeugen. Die Grundlage für die Wandlung von Strahlung in ein elektrisches Signal in der Photodiode ist bei diesen Ausführungsbeispielen das Überkoppeln des Steuersignales Pc aus der Wellenleiterschicht 12, 13 in die Zwischenschicht 15, die hier als Absorptionsschicht fungiert. Dieses Überkoppeln erfolgt mittels Leckwellenkopplung. Die als Absorptionsschicht fungierende Zwischenschicht 15 kann auch gleichzeitig als Kanalschicht fungieren. Eine eigene Kanalschicht 16 ist dann nicht vorhanden. Der Bandabstand der Zwischenschicht 15 ist bei diesen Ausführungsbeispielen so zu wählen, daß das Steuersignal Pc absorbiert wird und das Nutzsignal Ps nicht absorbiert wird, sondern die Photodiode 2 verlustfrei passieren kann. Der pn-Übergang für den p-Bereich der Photodiode 2 wird bei diesem Ausführungsbeispiel gleichzeitig mit dem pn-Übergang für den Gate-Bereich 19 des FETs 5 erzeugt. Bei der Herstellung dieser Ausführungsbeispiele ist eine Doppelepitaxie erforderlich, da nach dem Aufwachsen der Schichtfolge bis einschließlich der Zwischenschicht 15 die pn-Übergänge im Bereich des Richtkopplers 4 und des FETs 5 durch Diffusion oder Implantation von Dotierstoff hergestellt werden. In einem zweiten Epitaxieprozeß werden die Kanalschicht 16, die Deckschicht 17 und die Kontaktschicht 18 aufgewachsen. Die vergrabene p-Schicht für den FET 5 kann alternativ auch nach diesem zweiten Epitaxieprozeß durch Implantation von Dotierstoff hergestellt werden. Fig. 10 zeigt das Ausführungsbeispiel auf n-leitendem Substrat 10 mit einem Kontakt 23 auf der der überwachsenen Seite gegenüberliegenden Seite des Substrates. Fig. 11 zeigt die entsprechende Ausführungsform auf semiisolierendem Substrat mit auf einer Pufferschicht 11, die n-leitend dotiert ist, aufgebrachten Kontakten 24.

Der erfindungsgemäße NCM überträgt das optische Nutzsignal Ps nahezu verlustlos jeweils nur auf einen Ausgang. Deshalb kann insbesondere bei kleineren optischen Netzwerken auf optische Zwischenverstärker verzichtet werden.

Während die Übertragung des Informationssignals durch die optische Übertragungsgeschwindigkeit bestimmt wird, begrenzt das elektrische Zeitverhalten des optischen Schalters die Schnelligkeit des Umschaltvorganges.

Der Vorteil des erfindungsgemäßen NCMs liegt abgesehen von der Kaskadierbarkeit darin, daß neben der elektrischen Spannungsversorgung für die Photodioden, den Schalter und das Flip-Flop keine zusätzliche, externe elektrische Leitung zur Steuerung des Schalters benötigt wird. Die erforderlichen optischen Steuerimpulse Pc zur Festlegung des Übertragungsweges, d. h. zur Schaltung des Signalweges auf einen der alternativen Ausgänge, werden vor der Übertragung des Informationssignales gesendet. Das NCM kann für ATM-Systeme und STM-Systeme eingesetzt werden.

Mit dem erfindungsgemäßen NCM, der sowohl in DWDM-Systemen als auch in kohärenten Überlagungssystemen eingesetzt werden kann, können Nutzsignale in analoger und digitaler Form übertragen werden.

Dieser NCM kann auch dahingehend abgewandelt werden, daß statt eines R-S-Flip-Flop ein Mono-Flop oder eine astabile Kippstufe vorgesehen sind. Im ersten Fall (Mono-Flop) wird nach einer bestimmten Zeit der Schalter von Ausgang 2 ("Ein"-Zustand) selbstständig auf den Ausgang I ("Aus"-Zustand) umgeschaltet. Dabei kann auf eine Photodiode im Ausgang II verzichtet werden. Bei Verwendung einer astabilen Kippstufe kann auf beide Photodioden verzichtet werden, da keine Steuerimpulse benötigt werden und bei dieser Betriebsart beide Zustände nur eine bestimmte Zeit stabil sind. Als Anwendung ist das automatische Verteilen von Nutzsignalen Ps in einem bestimmten Zeitraster auf Ausgang I bzw. Ausgang II denkbar. Dann ist aber ein Synchronisierungssignal erforderlich.

**Patentansprüche**

1. Netzwerkkonfigurationsmodul (NCM) für die Vernetzung optischer Signalwege,
   bei dem ein optischer Schalter (1) in einem Signalweg mittels einer elektronischen Schaltung (3) geschaltet wird und
   bei dem diese elektronische Schaltung (3) Steuersignale verarbeitet, die von mindestens einer in dem optischem Signalweg angeordneten Photodiode (2) detektiert werden.

2. NCM nach Anspruch 1,
   bei dem eine Photodiode in einem Eingang des optischen Schalters angeordnet ist.

3. NCM nach Anspruch 1,
   bei dem eine Photodiode (2) in einem Ausgang (8) des optischen Schalters (1) angeordnet ist.

4. NCM nach Anspruch 1,
   bei dem in jedem Ausgang (8, 9) des optischen Schalters (1) eine Photodiode (2) angeordnet ist.

5. NCM nach einem der Ansprüche 1 bis 4,
   bei dem die elektronische Schaltung (3) ein R-S-Flip-Flop ist.

6. NCM nach einem der Ansprüche 1 bis 4,
   bei dem die elektronische Schaltung (3) ein Mono-Flop ist.

7. NCM nach einem der Ansprüche 1 bis 6
   in einer Kaskade eines Verteilnetzes.

**8.** NCM nach einem der Ansprüche 1 bis 6
in einer Schaltmatrix.

**9.** Netzwerkkonfigurationsmodul für die Vernetzung optischer Signalwege, bei dem ein optischer Schalter in einem Signalweg mittels einer integrierten astabilen Kippstufe periodisch umgeschaltet wird.

**10.** NCM nach einem der Ansprüche 1 bis 8,
bei dem zur Ausbildung eines Richtkopplers (4), der den optischen Schalter bildet, und zur Ausbildung einer Photodiode (2) und eines FETs (5) auf einer Grundschicht (10, 11) aus III-V-Halbleitermaterial, das für elektrische Leitfähigkeit eines ersten Leitfähigkeitstyps dotiert ist, übereinander eine Wellenleiterschicht (12, 13), eine Führungsschicht (14), eine Zwischenschicht (15) und zumindest im Bereich eines FETs eine Deckschicht (17) mit einem darin ausgebildeten Gate-Bereich (19) und eine Kontaktschicht (18) aufgewachsen sind,
bei dem die Führungsschicht (14) und die Zwischenschicht (15) zumindest im Bereich des Richtkopplers (4) und eines FETs (5) für elektrische Leitfähigkeit eines entgegengesetzten zweiten Leitfähigkeitstyps dotiert sind,
bei dem im Bereich einer Photodiode (2) ein pn-Übergang ausgebildet ist und
bei dem Kontakte (20, 21, 22, 23, 24) aus Metall für die elektrischen Anschlüsse vorgesehen sind.

**11.** NCM nach Anspruch 10,
bei dem die Zwischenschicht (15) als Absorptionsschicht für Steuersignale, die durch Leckwellenkopplung aus der Wellenleiterschicht (12, 13) in die Zwischenschicht (15) eingekoppelt werden, vorgesehen ist und
bei dem der Bandabstand der Zwischenschicht (15) sich derart von dem Bandabstand der Wellenleiterschicht (12, 13) unterscheidet, daß die Absorption auf Steuersignale beschränkt werden kann.

**12.** NCM nach Anspruch 10,
bei dem die Wellenleiterschicht (12, 13) so ausgebildet und zumindest die Führungsschicht (14) im Bereich einer Photodiode (2) so dotiert ist, daß bei Anliegen eines elektrischen Potentiales eine selektive Absorption von Steuersignalen in der Wellenleiterschicht unter Ausnutzung des Franz-Keldysh-Effektes bewirkt werden kann.

**13.** NCM nach einem der Ansprüche 10 bis 12,
bei dem im Bereich eines FETs (5) zwischen der Zwischenschicht (15) und der Deckschicht (17) eine Kanalschicht (16), die für den zweiten Leitfähigkeitstyp dotiert ist, vorhanden ist.

**14.** NCM nach einem der Ansprüche 10 bis 13,
bei dem die Wellenleiterschicht (12, 13) mindestens zwei übereinander angeordnete Schichten mit unterschiedlichem Bandabstand umfaßt.

**15.** NCM nach einem der Ansprüche 10 bis 14,
bei dem die Grundschicht ein Substrat (10) ist.

**16.** NCM nach einem der Ansprüche 10 bis 14,
bei dem die Grundschicht eine auf ein Substrat (10) aufgewachsene Pufferschicht (11) ist.

**FIG 1**

**FIG 2**

**FIG 5**

**FIG 6**

8

# FIG 3

# FIG 4

FIG 7

$U_B$    $U_G$ $U_D$

6

$R_S$    $R1_L$    8

1    $PD_S$    2

4    $PD_L$

$R2_S$    9

$R2_L$

10

5    5

$T_S$    $R1_S$

$T_L$    $R_L$

$U_B$ $U_G$ $U_D$

FIG 8

5

4    2    22

20    18    18    18

15    21    17

14    16

15    19

13    14

12    13

11    12

11

10

23

FIG 9

FIG 10

FIG 11